# EUROPEAN PATENT APPLICATION

(11) **EP 2 107 380 A1**
(43) Date of publication of application: **07.10.2009**
(21) Application number: 08425212.1
(22) Date of filing: 01.04.2008
(51) Int. Cl.: G01R 1/073

(54) **Testing head having vertical probes configured to improve the electric contact with a device to be tested**

(71) Applicant: Technoprobe S.p.A, 23870 Cernusco Lombardone (Lecco) (IT)
(72) Inventor: Crippa, Roberto, I-23870 Cernusco Lombardone (Lecco) (IT); Anghilieri, Paolo, I-23870 Cernusco Lombardone (Lecco) (IT)
(74) Representative: Zambardino, Umberto

(57) **Abstract**

A measuring head (40) with vertical probes, of the type comprising a plurality of contact probes (46), each housed in at least a respective guiding bore (44, 45), each contact probe (46) having a central rod-like body (57), with a predetermined longitudinal axis (L), with respective ends (58, 63) provided with a first contact tip (47B), for ensuring electrical and mechanical contact with a contact pad (48) of a device (52) to be tested, and a second contact tip (47A) for ensuring electrical and mechanical contact with a corresponding contact pad (51) of a test device (50), said contact pads (48) of device to be tested being substantially aligned along at least a predetermined alignment axis (X, Y). According to the invention, in at least some of said contact probes (46) respective second contact tips (47A) are eccentrically arranged with respect to said longitudinal axis (L) and said contact probes (46) are arranged with respective ends (58) having said second contact tips (47A) so that pitch (P) between contact pads (51) of test device (50) associated to consecutive contact probes (46) along said at least one alignment axis (X, Y) is greater than pitch (p) between corresponding contiguous contact pads (48) of device (52) to be tested, which are associated to said consecutive contact probes (46).

## Description

### Field of the invention

The present invention relates to a measuring head provided with vertical probes, of the type comprising a plurality of contact probes, each of the probes being housed in at least a corresponding guiding bore, each of the contact probes being provided with a rod-like central body, with a predetermined longitudinal axis, which is provided at respective ends with a first contact tip, for ensuring electrical and mechanical contact with a contact pad of a device to be tested and a second contact tip for ensuring electrical and mechanical contact with a corresponding contact pad of a test device, said contact pads of the device to be tested being substantially aligned along at least a predetermined alignment axis.

### Known art

As is known, a measuring head is generally a device which is designed for electrically connecting a plurality of contact pads of an electronic device integrated on a semiconductor, with respective contact pads of a printed circuit, which in turn is connected by means of conductive strips with a measuring machine, performing a test on integrated electronic semiconductor devices.

Tests performed on integrated electronic devices allow identification and isolation of already faulty devices, during the production step. Normally, measuring heads are used for electrical testing of semiconductor integrated electronic devices, or silicon wafers, prior to cutting and assembling of same inside a chip containment package.

The connection between the contact pads of the integrated electronic device and corresponding contact pads on the printed circuit board takes place by means of the contact head containing a plurality of contact elements or probes.

In particular, such contact probes are normally formed by wires of special alloys having good electrical and mechanical properties.

A good contact between the contact probes and contact pads is moreover ensured by pressure exacted by each probe during operation, when mobile contact probes bend elastically.

Such a measuring head with vertical probes comprises at least a pair of parallel plates or plate-like supports, which are positioned at a certain distance to each other in order to leave an air gap, and also a plurality of contact probes.

Each plate, called plate-like die in the relevant technical field and in the following description, is provided with a respective plurality of through guiding bores, wherein to each bore of one plate corresponds a bore of the other plate, in which a respective contact probe is slidingly engaged and guided. In particular, mobile contact probes bend elastically inside the air gap between the two plate-like dies.

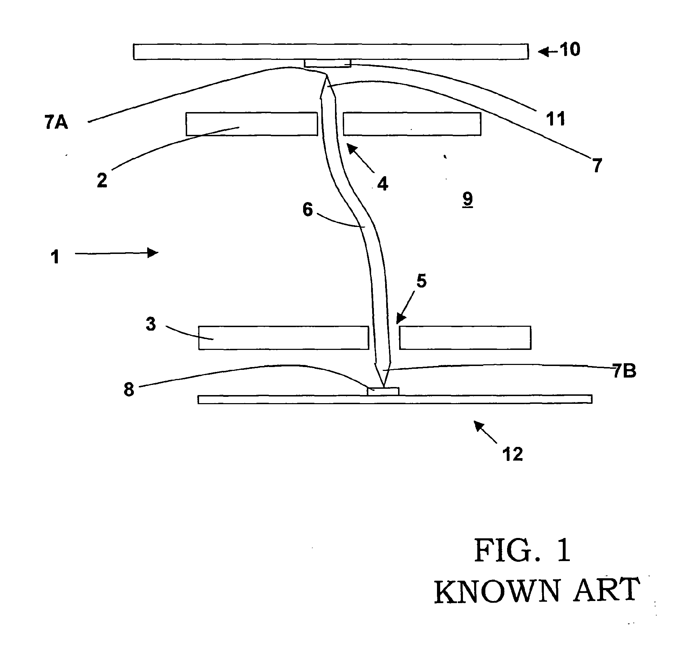

As schematically shown in fig. 1, a measuring head 1 of known type comprises at least an upper die 2 and a lower lower die 3, which are provided with respective upper and lower guiding bores 4 and 5, in which at least a contact probe 6 is slidingly provided.

Each contact probe 6 comprises an upper end or contact tip 7A and a lower end or contact tip 7B, which are substantially equivalent, as shown in fig. 1, wherein, for sake of clarity, only one contact probe is shown. In particular, the lower contact tip 7B has a contact surface, in an advanced position, which is in mechanical contact with a contact pad 8 of an integrated electronic device 12 to be tested.

The upper upper die 2 and lower die 3 are suitably separated by an air gap 9, which allows deformation or slanting of contact probes 6 during normal operation of measuring head, in other words, when the measuring head contacts the integrated electronic device to be tested. Moreover, upper and lower guiding bores 4, 5 are suitably sized in order to guide the respective contact probe 6.

The measuring head 1 is of the type with unblocked probes, associated to a microcontactor (of the "space transformer" type or a printed circuit board or PCB, depending on the characteristics), which is generally indicated by 10. The microcontactor 10 electrically connects contact probes 6 housed by the measuring head with channels of test apparatus.

In this case, the upper end or contact tip 7A of contact probes 6 is directed towards a plurality of contact pads of microcontactor 10, a good electrical contact between contact probes 6 and the microcontactor 10 being ensured in a way similar to the contact with the integrated electronic device to be tested by means of contact probes 6 pressing on contact pads 11 of microcontactor 10.

As is known, technological evolution and chip miniaturization requires increasing reduction of distance separating contact pads 8 of device 12 to be tested, said distance being known in the field as "pitch".

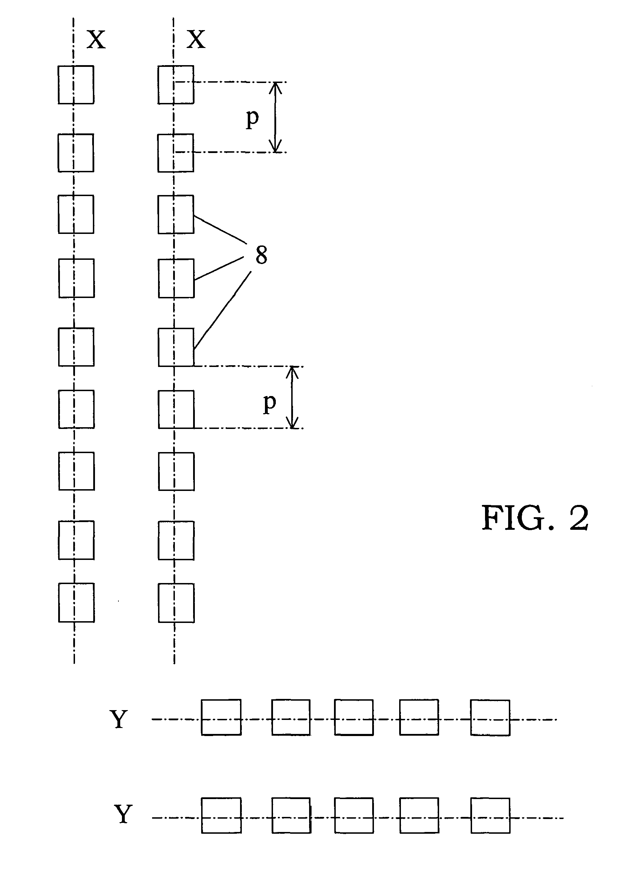

In particular, as shown in fig. 2, contact pads 8 of device 12 to be tested are normally aligned along alignment axis X and Y, the pitch p being defined as the distance between two equivalent points of consecutive pads, along respective alignment axis X or Y, for instance the distance between centers of said consecutive pads.

Therefore, aforementioned distance reduction separating contact pads 8 of device to be tested requires, in above said microcontactors, a corresponding reduction of distance separating contact pads 11 of microcontactor 10.

But such a reduction of distance between contact pads 11 is technically complex and entails higher manufacturing costs of microcontactor 10.

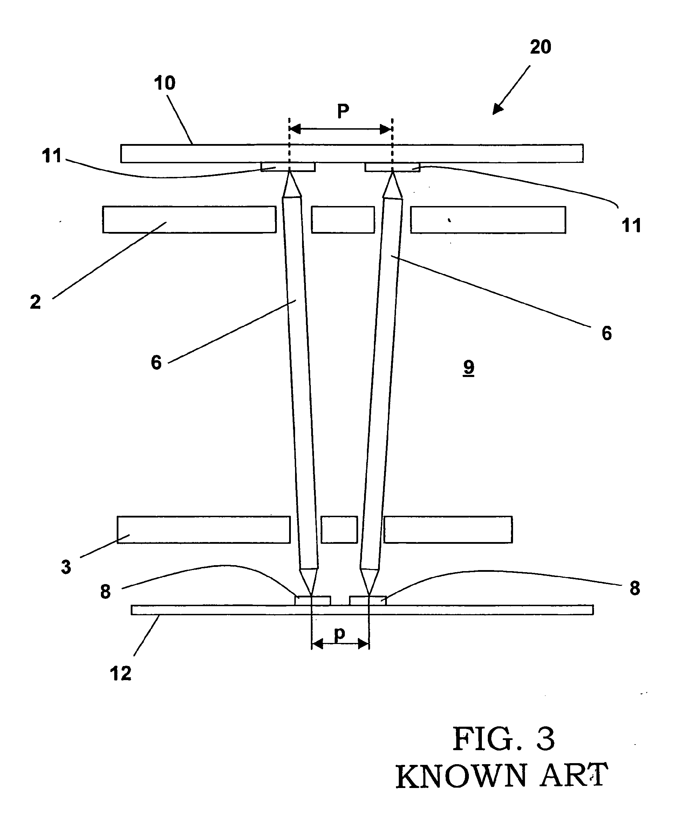

In order to obviate to such drawbacks, the known art teaches a greater distancing of contiguous upper guiding bores 4 of upper die 2 with respect to corresponding lower guiding bores 5 of lower die 3, as shown in the case of measuring head 20 of fig. 3, in which common elements of measuring head 1 of fig. 1 are provided with same reference numerals.

In this way, distance between two contiguous upper guiding bores 4 of upper die 2 is greater than distance between respective lower guiding bores 5 of lower die 3. Therefore, distance between corresponding contact pads 11 of microcontactor 10 (measured as the distance between equivalent points on two consecutive contact pads 11, also called pitch and provided with a uppercase P), is greater than pitch of pads 8 of device 12, indicated by p.

Unfortunately, it is not possible to excessively modify the distance between upper guiding bores 4 of upper die 2 with respect to corresponding lower guiding bores 5 of lower die 3, because this may cause other drawbacks, such as reduced sliding properties of contact probes 6 in guiding bores 4 and 5 and reduced planarity among contact tips, due to a different inclination of contact probes, which can compromise a good electrical contact with contact pads and therefore a good operation of measuring head. Such loss of planarity may be compensated by providing contact probes of different length, but this gives rise to a higher complexity in construction and use of probes of measuring head, as well as a corresponding increase of manufacturing costs.

The technical problem to be solved by the present invention is to provide a measuring head having characteristics such as to allow an increase of pitch among pads of test device with respect to pitch of corresponding pads of an electronic device to be tested, without displaying aforementioned drawbacks of the known art.

### Summary of the invention

According to the invention, the present technical problem is solved by a measuring head provided with vertical probes, of the type comprising a plurality of contact probes, each housed in at least a respective guiding bore, the contact probes each having a central body, with a predetermined longitudinal axis, which is provided at respective ends with a first contact tip, suitable for ensuring an electrical and mechanical contact with a contact pad of a device to be tested and a second contact tip suitable for ensuring an electrical and mechanical contact with a corresponding contact pad of a test device, said contact pads of the device to be tested being substantially aligned along at least a predetermined alignment axis, **characterized in that**, in at least some of said contact probes, the respective second contact tips are displaced in eccentric fashion with respect to said longitudinal axis, and in that said contact probes are arranged with respective ends provided with said second contact tips so that the pitch between contact pads of the test device which are associated to consecutive contact probes along said at least one alignment axis is greater than the pitch between corresponding contact pads of the device to be tested which are associated to said consecutive contact probes.

Preferably, the eccentric contact tips are arranged in an advanced position on respective protruding arms of said central rod-like body of contact probes.

Preferably, in a measuring head according to the invention, the protruding arms of contact probes provided with eccentric contact tips are arranged in alternatively opposed position, with respect to contact pads of the device to be tested, along at least said alignment axis.

Preferably, in a measuring head according to the invention, the protruding arms of contact probes provided with eccentric contact tips are arranged in alternatively opposed position with respect to contact pads of device to be tested, along at least two alignment axis of contact pads, which are perpendicular to each other.

According to a preferred embodiment of the invention, the protruding arms are of different length.

Preferably, the measuring head according to the invention comprises contact probes having first protruding arms of shorter length, alternating with contact probes having second protruding arms of greater length, along said at least one alignment axis of contact pads of device to be tested.

Preferably, the first shorter protruding arms and second longer protruding arms are arranged on same side with respect to an alignment axis of contact pads of device to be tested.

Preferably, in a measuring head according to the invention, protruding arms are slanted, forming a predetermined angle with respect to one alignment axis of contact pads of device to be tested. Preferably, such predetermined angle is about 45°.

According to an embodiment of the measuring head according to the invention, the protruding arms extend beyond the profile of transversal section of rod-like body of respective contact probes.

### Brief description of drawings

In particular:
- fig. 1 shows an example of a measuring head of the known art,
- fig. 2 shows an example of contact pads of a device to be tested, said contact pads being aligned to each other,
- fig. 3 schematically shows a second example of a measuring head according to the known art,
- fig. 4 schematically shows a lateral view of a first embodiment of the present invention, in which, for sake of clarity, only one contact probe is illustrated,
- fig. 5, 6 and 7 schematically show upper views of the arrangement of a plurality of contact probes in measuring heads according to the invention.

### Detailed description

Fig. 1 and 3 show already described measuring heads 1 and 20 according to the known art. Fig. 2 shows an exemplary arrangement of contact pads of a device to be tested, which are aligned according to alignment axis X and Y.

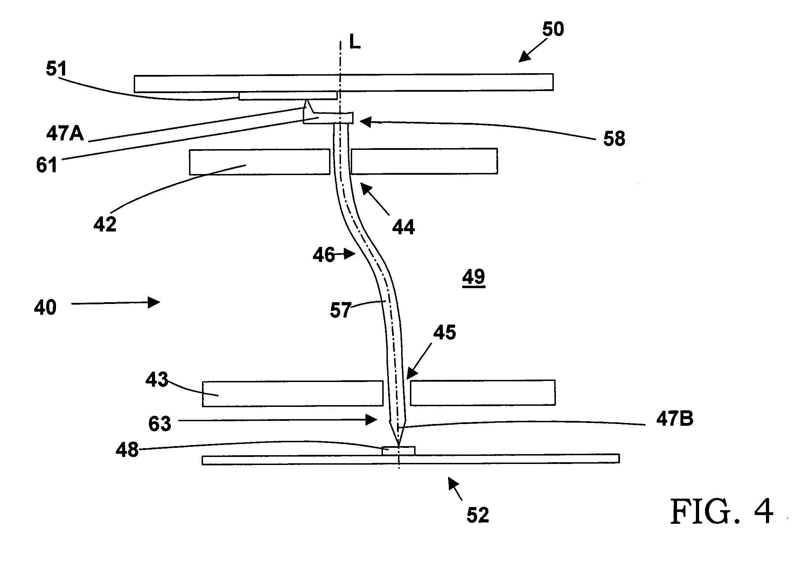

A measuring head according to the invention, shown in fig. 4 and generally indicated by numeral 40, electrically contacts a plurality of pads 48 of a device 52 to be tested with a corresponding plurality of pads 51 of a microcontactor 5 of a test device.

Measuring head 40 is of the type having unblocked probes, and comprises an upper guide (upper die) 42 and a lower guide (lower die) 43, which are held apart by means of a distancing means, not shown, in order to define an air gap 49. Upper guide 42 and lower guide 43 both have a plurality of respective upper guiding bores 44 and lower guiding bores 45, in which a plurality of contact probes 46 is slidingly fitted. For sake of clarity, in fig. 4, only one contact probe 46 is shown, which is housed in a respective upper guiding bore 44 and lower guiding bore 43.

Contact probes 46 in measuring head 40 are composed of a metallic conducting material, for example a metal alloy, and may be comprised of only one material or different material layers, according to specific needs.

Contact probes 46 extend in a longitudinal direction, along a predetermined axis L, and in the present embodiment, have a polygonal transversal section, for instance of rectangular or square shape. In use, contact probes 46 are subject to bending and/or deformations, as shown before with reference to the known art. Obviously, contact probes 46 may have a transversal section different from polygonal, for example a circular or elliptic transversal section.

More particularly, each contact probe 46 comprises a central rod-like body 57, which extends along said predetermined longitudinal axis L and an upper end portion 58 protruding beyond upper die 42, and ending with a contact tip 47A for electrically and mechanically contacting a respective contact pad 51 of microcontactor 50. Moreover, each contact probe 46 comprises a lower end portion 63 protruding beyond lower die 43, and a lower contact tip 47B for electrically and mechanically contacting a respective contact pad 48 of device to be tested 52. In this way, once the contact pads 51 of microcontactor 50 are put into contact with contact tips 47A of respective contact probes 46 and contact pads 48 with contact tips 47B of said probes 46, it is possible to measure electrical characteristics associated with contact pads 48 and therefore verify the function of device 52 to be tested.

Advantageously, the upper guiding bore 44 of upper die 42 has a polygonal shape, for example a rectangular or square shape, similar to that of central rod-like body 57 (but of slightly greater size, in order to define a certain clearance), so that to allow sliding but at the same time inhibiting rotation of contact probe 46 about its longitudinal axis L.

According to the invention, contact tips 47A of at least some of plurality of contact probes 46 fitted into measuring head 40 are eccentric with respect to longitudinal axis L. In particular, in the present embodiment, in at least some of contact probes 46, respective upper end portions 58 are each composed of an arm 61 extending in a substantially perpendicular direction with respect to said longitudinal axis L, and ending in an advanced position, with an eccentric contact tip 47A.

Advantageously, each arm 61 extends beyond the profile of transversal section of central rod-like body 57, in order to define a generally step-like profile along longitudinal axis L; in this way, contact probes 46 are correctly held in position with respective upper ends 58 positioned above upper guiding bores 44, without passing through them.

Moreover, as will be explained in the following, contact probes 46 are at least partially arranged with respective end portions 58 having contact tips 47A so that the pitch between contact pads of test device which are associated to consecutive contact probes, along said at least one alignment axis of contact pads of the device to be tested, is greater than the pitch between the corresponding contact pads of the device to be tested which are associated to said consecutive contact probes.

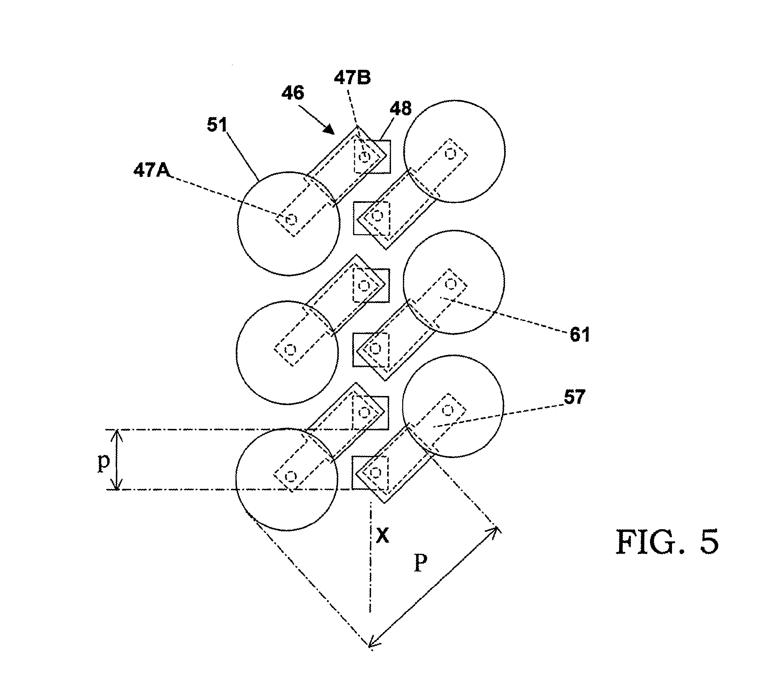

In fig. 5, an exemplary arrangement of some of plurality of contact probes 46 of measuring head 40 according to the invention, are shown, wherein, for sake of clarity, upper die 42, lower die 43 and guiding bores 44 and 45 are not shown. Moreover, as far as the microcontactor 50 is concerned, only contact pads 51 are illustrated.

In this exemplary embodiment, contact pads 48 of device 52 to be tested are aligned according to axis X and contact probes 46 are arranged in an alternate opposed position, with respect to alignment axis X of contact pads 48.

In this way, it is possible to set the contact pads 51 of microcontactor 50 farther apart, in particular with respect to contact pads 51 associated to contact probes 46 which are consecutively displaced along alignment axis X of contact pads 48 of the device to be tested. More in particular, as shown in fig. 5, due to present arrangement of contact probes 46, pitch p between contact pads 48 which are consecutively displaced along alignment axis X is smaller than the distance between contact tips 47A of contact probes 46 associated to said consecutive contact pads 48. Therefore, contact pads 51 may be positioned on microcontactor 50 so that pitch P between contact pads 51 associated to consecutive contact probes 46 is greater than pitch p between corresponding contact pads 48 associated with said consecutive contact probes 46.

Advantageously, protruding arms 61 of contact probes 46 are inclined so that to enclose a predetermined angle of about 45° with respect to alignment axis X of contact pads 48 of device 52 to be tested.

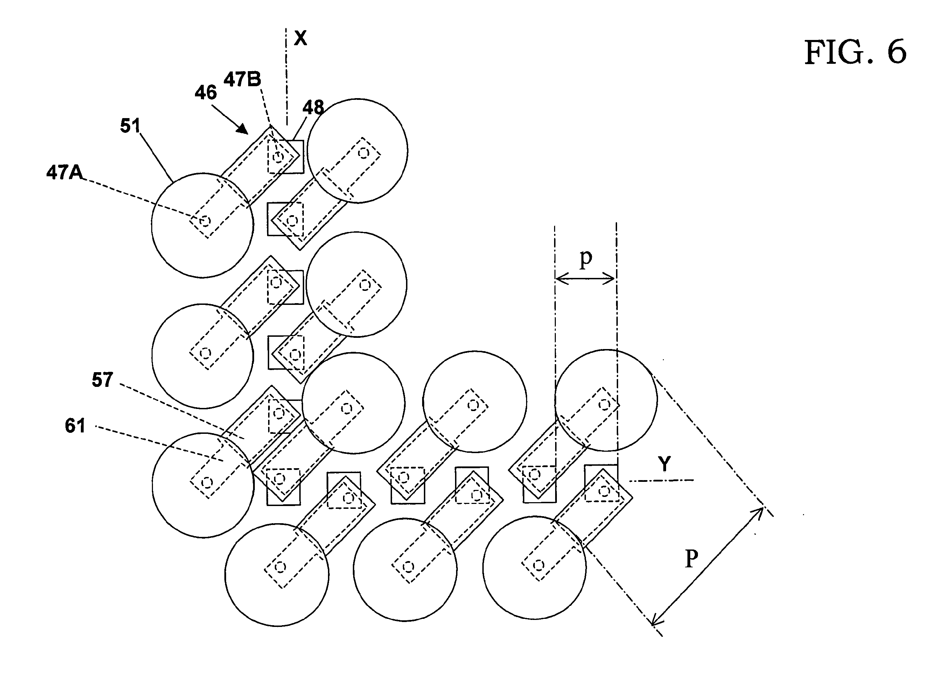

In fig. 6, another exemplary embodiment of some of plurality of contact probes 46 of measuring head 40 according to the invention is shown. In this example, contact pads 48 of device 52 to be tested are aligned according to two alignment axis X, Y, which are mutually perpendicular and said contact probes 46 are arranged in an alternate opposed position with respect to alignment axis X or Y.

In this case, it is therefore possible to set contact pads 51 of microcontactor 50 farther apart, in particular with reference to contact pads 51 associated with consecutive contact probes 46 along alignment axis X or Y of contact pads 48 of device to be tested. More particularly, as shown in fig. 6, due to present embodiment of contact probes 46, pitch p between consecutive contact pads 48 along alignment axis X or Y is smaller than the distance between contact tips 47A of contact probes 46 associated with said consecutive contact pads 48.

Therefore, contact pads 51 may be arranged on microcontactor in order that pitch P between contact pads 51 associated with consecutive contact probes 46 is greater than pitch p between corresponding contact pads 48 associated with said consecutive contact probes 46. Advantageously, protruding arms 61 of contact probes 46 are inclined with a predetermined angle α of about 45°, with respect to alignment axis X or Y, of contact pads 48 of device to be tested 52, in order to allow useful application of measuring head 40 according to the invention also on contact pads located at intersections of said alignment axis X and Y.

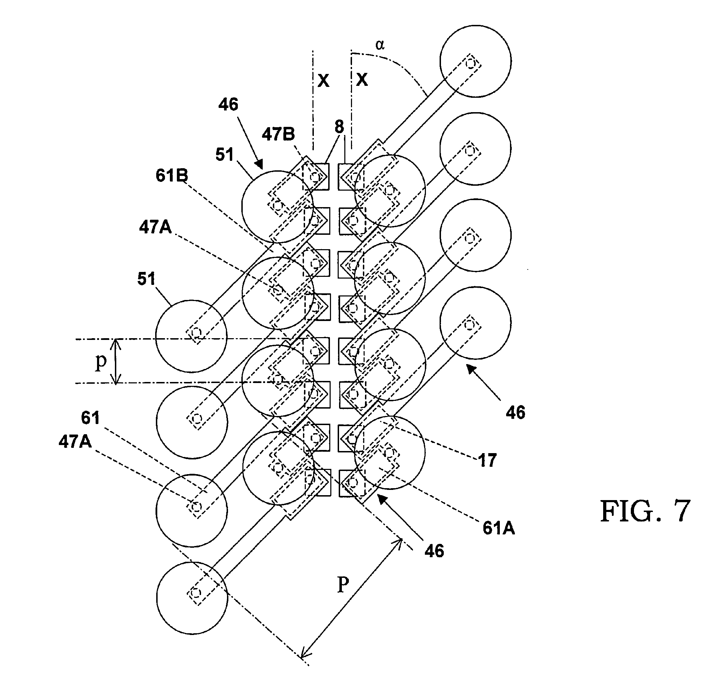

Fig. 7 shows a further exemplary embodiment of some of a plurality of contact probes 46 of a measuring head 40 according to the invention. In this example, contact pads 48 of device 52 to be tested are aligned along two parallel alignment axis X and said contact probes 46 have protruding arms of variable length.

In particular, along alignment axis of contact pads 48 of device 52 to be tested, contact probes 46 with shorter protruding arms 61A are interleaved with contact probes 46 with longer protruding arms 61B.

Moreover, shorter protruding arms 61A and longer protruding arms 61B are disposed on the same side with respect to alignment axis X of contact pads 48 of device 52 to be tested. In this case, it is therefore possible to place the contact pads 51 of microcontactor 50 farther away from each other, in particular with reference to contact pads 51 associated with contact probes 46 which are consecutively displaced along any of parallel alignment axis X of contact pads 48 of device to be tested. More particularly, as shown in fig. 7, due to present embodiment of contact probes 46, pitch p between contact pads 48 which are consecutively displaced along any of parallel alignment axis X is smaller than the distance between contact tips 47A of contact probes 46 associated with consecutive contact pads 48. Therefore, contact pads 51 of microcontactor may be disposed so that pitch P between contact pads 51 associated to consecutive contact probes 46 is greater than pitch p between corresponding contact pads 48 associated to consecutive contact probes 46.

Advantageously, protruding arms 61 of contact probes 46 are inclined so that to form a predetermined angle of about 45° with respect to respective alignment axis X of contact pads 48 of device 52 to be tested.

The primary advantage of a measuring head according to the invention is that it allows a simple increase of pitch between contact pads on microcontactor of test device with respect to pitch of contact pads of device to be tested, at the same time preserving correct function of measuring head and ensuring correct planarity among probes contact tips.

Therefore, the measuring head according to the invention may be manufactured at lower costs, and contact pads of test device may be advantageously provided with greater size, increasing the available contact area with respective tips of contact probes. Due to increased surface area of contact pads on microcontactor, it is moreover possible to ensure a good although limited electrical contact, even in case of alignment errors between microcontactor pads and corresponding tips of contact probes.

A further advantage of a measuring head according to the invention is that it compensates differences due to thermal expansion between test device and upper guide (since these elements are composed of materials having quite different thermal expansion coefficients), in case of function testing at high temperatures, due to greater area surface of contact pads on microcontactor, ensuring good, although limited, electrical contact with respective tips of contact probes.

Obviously, the skilled in the art, in order to comply with contingent and specific needs, may introduce various modifications and changes to the measuring head according to the invention, which are all comprised in the protection scope defined by the claims. For example, in the measuring head according to the invention, all contact probes may be provided with eccentric tips, for contacting pads of the space transformer, or a mix of contact probes with eccentric tips and contact probes with non eccentric tips may be provided, wherein contact probes of measuring head are in any case arranged so that pitch between contact pads of test device associated with consecutive contact probes along at least one predetermined alignment axis of contact probes to be tested is greater than pitch of contact pads associated to said consecutive contact probes.

## Claims

1. A measuring head (40) with vertical probes, of the type comprising a plurality of contact probes (46), each housed in at least a respective guiding bore (44, 45), each contact probe (46) having a central rod-like body (57), with a predetermined longitudinal axis (L), with respective ends (58, 63) provided with a first contact tip (47B) suitable for ensuring electrical and mechanical contact with a contact pad (48) of a device (52) to be tested, and a second contact tip (47A) suitable for ensuring electrical and mechanical contact with a corresponding contact pad (51) of a test device (50), said contact pads (48) of the device to be tested being substantially aligned along at least a predetermined alignment axis (X, Y), **characterized in that**, in at least some of said contact probes (46), said respective second contact tips (47A) are arranged in eccentric fashion with respect to said longitudinal axis (L) and **in that** said contact probes (46) are arranged with respective ends (58) having said second contact tips (47A), so that the pitch (P) between contact pads (51) of the test device (50) which are associated to consecutive contact probes (46) along said at least one alignment axis (X, Y) is greater than the pitch (p) between the corresponding contiguous contact pads (48) of the device (52) to be tested which are associated to said consecutive contact probes (46).

2. A measuring head according to claim 1, **characterized in that** said second eccentric contact tips (47A) are arranged in an advanced position on respective arms (61; 61A, 61B) protruding from central rod-like body (57) of said contact probes (46).

3. A measuring head according to claim 2, **characterized in that** said protruding arms (61; 61A, 61B) of contact probes (46) provided with said second eccentric contact tips (47A) are arranged in a alternate opposed position with respect to contact pads (48) of device (52) to be tested, along at least said alignment axis (X, Y).

4. A measuring head according to claim 3, **characterized in that** said protruding arms (61; 61A, 61B) of contact probes (46) provided with said second eccentric contact tips (47A) are arranged in an alternate opposed position with respect to contact pads (48) of device (52) to be tested, along at least two alignment axis (X, Y) of said contact pads (48), which are substantially perpendicular to each other.

5. A measuring head according to any of claims 2 to 4, **characterized in that** said protruding arms (61A, 61B) are of different length.

6. A measuring head according to claim 5, **characterized in that** it comprises contact probes (46) provided with first protruding arms (61A) of shorter length, interleaved by contact probes (46) provided with second protruding arms (61B) of greater length, along at least said alignment axis (X, Y) of said contact pads (48) of device (52) to be tested.

7. A measuring head according to claim 6, **characterized in that** said first shorter protruding arms (61A) and said second longer protruding arms (61B) are arranged on same side with respect to an alignment axis (X) of said contact pads (48) of device (52) to be tested.

8. A measuring head according to any of claims 2 to 7, **characterized in that** said protruding arms (61; 61A, 61B) are inclined to form a predetermined angle (α) with respect to an alignment axis (X, Y) of said contact pads (48) of device (52) to be tested.

9. A measuring head according to claim 8, **characterized in that** said predetermined angle (α) is about 45°.

10. A measuring head according to any of claims 2 to 9, **characterized in that** each arm (61; 61A, 61B) extends beyond profile of transversal section of said central rod-like body (57), in order to define a substantially step-like profile along longitudinal axis (L).
